Europäisches Patentamt

European Patent Office

Office européen des brevets

(11) Numéro de publication: **0 240 436 B1**

## FASCICULE DE BREVET EUROPEEN

(45) Date de publication de fascicule du brevet: **17.06.92**

(51) Int. Cl.5: **H02M 3/07**, H03K 17/687, H01L 27/06

(21) Numéro de dépôt: **87400743.8**

(22) Date de dépôt: **03.04.87**

(54) **Multiplicateur de tension continue pouvant être intégré à une structure semiconductrice.**

(30) Priorité: **04.04.86 FR 8604859**

(43) Date de publication de la demande:
**07.10.87 Bulletin 87/41**

(45) Mention de la délivrance du brevet:
**17.06.92 Bulletin 92/25**

(84) Etats contractants désignés:
**BE DE ES GB IT NL SE**

(56) Documents cités:
**EP-A- 0 134 731
FR-A- 2 458 936**

**NEW ELECTRONICS, vol. 18, no. 13, 25 juin
1985, page 25, Londres, GB; G. PECKHAM:
"CMOS driver for high treshold MOSFETS"**

**PATENT ABSTRACTS OF JAPAN, vol. 9, no.
212 (E-339)[1935], 29 août 1985; & JP-A-60 74
665 (NIPPON DENKI K.K.) 26-04-1985**

(73) Titulaire: **THOMSON-CSF
51, Esplanade du Général de Gaulle
F-92800 Puteaux(FR)**

(72) Inventeur: **Nadd, Bruno
THOMSON-CSF SCPI 19, avenue de Messine
F-75008 Paris(FR)**

(74) Mandataire: **de Beaumont, Michel
1bis, rue Champollion
F-38000 Grenoble(FR)**

Rank Xerox (UK) Business Services

## Description

La présente invention concerne un multiplicateur de tension continue pouvant être intégré à une structure semiconductrice notamment pour commander un transistor de puissance élaboré sur un substrat semiconducteur.

Les applications croissantes de l'électronique à tous les secteurs industriels conduisent à une multiplication des longueurs de câbles électriques. En particulier dans les automobiles, le câblage électrique des différents organes est de plus en plus complexe, chacun d'eux étant pratiquement commandé individuellement. D'une manière générale, ce câblage se fait sous la forme d'un faisceau de fils de plus en plus volumineux dont le contrôle et le dépannage après montage sont pratiquement impossibles. La solution à ce problème réside en l'utilisation du multiplexage. Chaque accessoire ayant la faculté de reconnaître l'information qui le concerne, on peut donc relier tous ces accessoires par un même fil de commande. Un tel type de multiplexage conduit à l'association sur un même substrat d'un transistor de puissance et de sa logique de commande. L'un des problèmes soulevés par cette nouvelle conception de l'électronique automobile est la commande d'un transistor de puissance en série avec une charge. En particulier, si le transistor de puissance est du type VD MOS (transistor à effet de champ à structure verticale et à canal diffusé) il faut, pour le rendre conducteur, appliquer sur sa grille une tension plus élevée que celle existant entre sa source et son drain. Le VD MOS et sa charge étant branchés directement sur la batterie d'accumulateurs, il faut donc disposer d'une tension continue supérieure à la tension de batterie. Puisqu'on ne désire pas introduire une autre source de tension continue dans une automobile, on doit donc avoir recours à un multiplicateur de tension.

On connaît des multiplicateurs de tension continue basés sur la charge et la décharge d'un condensateur et la commande par un signal d'horloge. De tels dispositifs comprennent au moins deux diodes et sont réalisés en éléments discrets nécessitant donc des fils de connexion. Puisque l'on désire éviter autant que possible les fils de câblage, on doit intégrer ce multiplicateur sur le même substrat que le VD MOS. Pour des raisons de simplification de fabrication, on souhaite réaliser le circuit logique de commande du VD MOS directement dans le substrat qui sert de drain au VD MOS sans isolement particulier entre la zone constituant le VD MOS et la zone de la logique. On peut alors profiter des opérations de diffusion qui serviront à élaborer le VD MOS pour intégrer sur le substrat les diodes citées plus haut. Par exemple, si le substrat est de type N, on pourra profiter de l'opération consistant à diffuser une zone de type P (afin de réaliser le canal du VD MOS) pour implanter également un caisson de type P formant l'anode d'une diode. On profiterait alors de la diffusion de type N nécessaire pour former la source du VD MOS pour implanter également dans le caisson P une région N formant la cathode de la diode. Cette solution qui paraît séduisante n'est cependant pas envisageable. En effet, il sera impossible d'obtenir sur la grille du VD MOS une tension supérieure à la tension batterie à cause de la jonction constituée entre le caisson P de la diode et le substrat de type N qui est lui-même porté au potentiel de la batterie. Une solution à ce problème consiste à isoler la diode ainsi créée du substrat. Une telle isolation implique des opérations particulières (création d'une couche enterrée, d'anneaux de garde, etc...) qui ne peuvent être exécutées en même temps que l'élaboration du VD MOS. Ces étapes supplémentaires entraîneraient une augmentation importante du prix de revient du dispositif semiconducteur.

Afin de pallier ces inconvénients, l'invention propose de remplacer la diode attaquant la grille du VD MOS par une résistance constituée à partir d'un transistor MOS à déplétion et de modifier le rapport cyclique du signal d'horloge afin que cette résistance se comporte comme la diode du circuit multiplicateur classique.

Il faut noter que le multiplicateur de tension selon l'invention a été imaginé pour résoudre un problème concernant une structure semiconductrice particulière. Cependant, le nouveau schéma électrique ainsi mis au point peut être utilisé dans d'autres applications dans le cas où une structure classique ne conviendrait pas.

L'invention a donc pour objet un multiplicateur d'une tension continue avec les caractéristiques de la revendication 1.

La résistance reliée au dispositif à commander peut avantageusement être réalisée au moyen d'un transistor MOS à déplétion ayant sa grille reliée à l'une de ses deux autres électrodes.

L'invention concerne également l'intégration du multiplicateur de tension sur un substrat semiconducteur notamment lorsque le dispositif à commander est un VD MOS élaboré à partir d'un substrat de type N, ledit transistor MOS à déplétion étant élaboré à partir d'un premier caisson de type P, le condensateur étant élaboré à partir d'un second caisson de type P.

Le premier caisson étant porté au potentiel de ladite tension continue de valeur déterminée, ladite diode sera alors constituée par la jonction existant entre la zone de type P dudit premier caisson et la zone de type N du transistor MOS à déplétion qui est reliée au condensateur.

L'invention sera mieux comprise et d'autres avantages apparaîtront au moyen de la description qui va suivre et des figures annexées parmi lesquelles :

- la figure 1 est un schéma électrique représentant un VD MOS associé à une charge,
- la figure 2 est un schéma électrique comportant un multiplicateur de tension selon l'art connu,
- la figure 3 représente un substrat semiconducteur associant un transistor de puissance et une diode,
- les figures 4 et 5 représentent des transistors MOS utilisés sous forme de diodes,
- les figures 6 et 7 sont des schémas électriques comportant des multiplicateurs de tension selon l'invention,
- la figure 8 représente une structure semiconductrice selon l'invention.

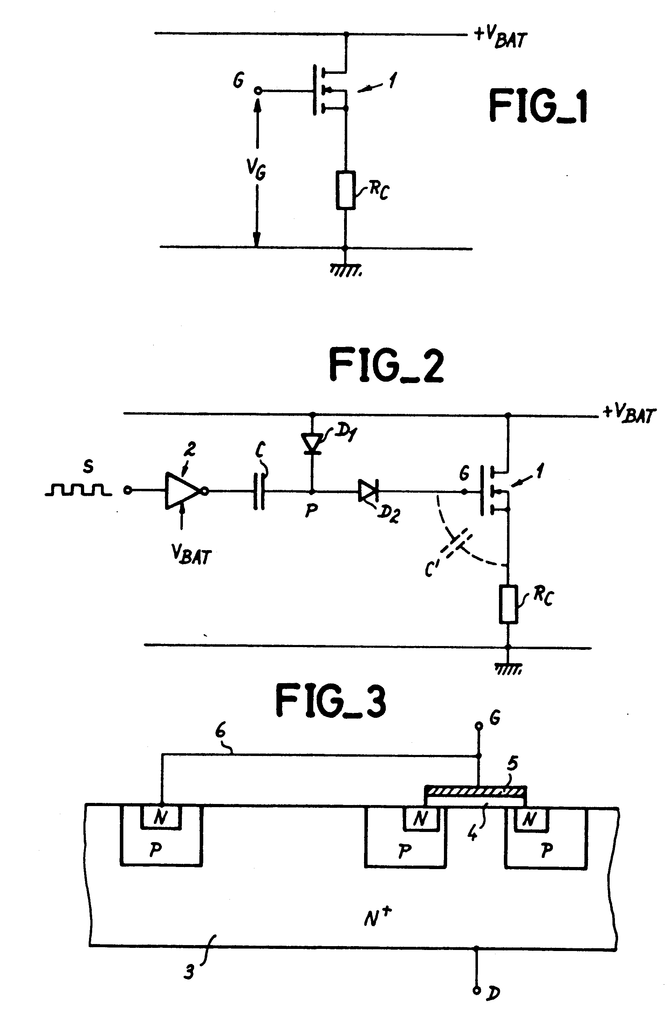

La figure 1 est un schéma électrique représentant un VD MOS référencé 1 en série avec une charge $R_c$. Cet ensemble est branché aux bornes de la batterie d'une automobile et la charge $R_c$ peut par exemple figurer les phares du véhicule. Pour rendre le transistor 1 conducteur, il faut appliquer sur sa grille G une tension $V_G$ supérieure à la tension drain, c'est-à-dire supérieure à la tension $V_{BAT}$. La saturation du VD MOS est obtenue pour une tension $V_G$ supérieure d'environ 5 volts à la tension drain. Pratiquement et pour plus de sécurité, on prendra $V_G = V_{BAT} + 10$ V. Pour une batterie de 12 V, la tension grille sera donc de 22 V. En l'absence d'autre source de tension continue il faut donc introduire un multiplicateur de tension continue et ce dispositif doit être intégré sur le même substrat que le VD MOS.

La figure 2 représente le schéma électrique d'un multiplicateur de tension continue du type décrit dans FR-A-2 458 936 associé au circuit de la figure 1. On a représenté sur la figure 2 la capacité C' existant entre la grille et le substrat du transistor 1. Le multiplicateur comprend deux diodes $D_1$ et $D_2$ placées en série entre la tension $V_{BAT}$ et la grille du transistor 1. Un circuit comprenant un inverseur 2 en série avec un condensateur C est relié au point P commun aux deux diodes $D_1$ et $D_2$. L'entrée de l'inverseur est susceptible de recevoir un signal d'horloge S. Le fonctionnement du dispositif est le suivant. Si le signal d'horloge S à l'entrée de l'inverseur vaut "1", sa sortie est au potentiel de la masse et le condensateur C se charge à $V_{BAT}$. Lorsque le signal d'horloge passe à "0", la sortie de l'inverseur passe à "1", c'est-à-dire à $V_{BAT}$. Alors la tension au point P vaut 2 $V_{BAT}$. Cette tension va permettre la conduction du VD MOS après une succession de charges et de décharges des capacités C et C'. On cherchera à avoir un inverseur de faible puissance. Pour ce faire, la capacité C sera suffisamment petite par rapport à C'. Si la capacité C' est environ 10 fois plus grande que la capacité C, il suffira de 10 impulsions d'horloge pour rendre le VD MOS passant. Pour un signal d'horloge de 1 MHz la commande des phares par exemple se fera en 10 $\mu$s.

Le problème qui se pose d'abord lorsque l'on veut passer à l'intégration du multiplicateur de tension sur le substrat du VD MOS est la réalisation de la diode qui attaque la grille. Si le substrat supportant le VD MOS est de type N, la solution qui vient à l'esprit est de réaliser un caisson P puis d'implanter une zone N pour obtenir une diode. La figure 3 représente une telle solution. Sur la partie du substrat 3 de type N$^+$ située à droite de la figure on a élaboré un VD MOS représenté de façon simplifiée. Ce transistor comprend deux caissons P dans lesquels des zones implantées N ont été réalisées. Les références 4 et 5 représentent respectivement la couche d'isolant de grille et le contact de grille. On a réalisé sur la partie gauche du substrat 3 une diode en profitant des opérations d'implantations P et N qui ont servi à la fabrication du VD MOS. La cathode de la diode ainsi constituée est réunie par une métallisation 6 à la grille du VD MOS pour satisfaire au schéma électrique de la figure 2. Cette manière de procéder paraît satisfaisante. Cependant, il sera impossible avec une telle configuration d'obtenir 2 $V_{BAT}$ au point P. En effet, le condensateur C étant chargé à $V_{BAT}$ grâce à une première impulsion d'horloge, dès que la partie P de la jonction constituant la diode D2 passe audessus de ce potentiel, la jonction constituée par cette partie P et le substrat N$^+$ porté au potentiel $V_{BAT}$ de drain, devient passante. Le condensateur C se décharge vers la batterie au lieu de se décharger vers la grille du VD MOS. Le remède à ce problème consisterait à isoler la diode $D_2$ du reste du substrat en utilisant des solutions connues (caisson, couche enterrée, etc.). Mais on introduit alors des étapes supplémentaires dans le procédé de fabrication. Ces étapes supplémentaires étant indésirables, il faut procéder autrement.

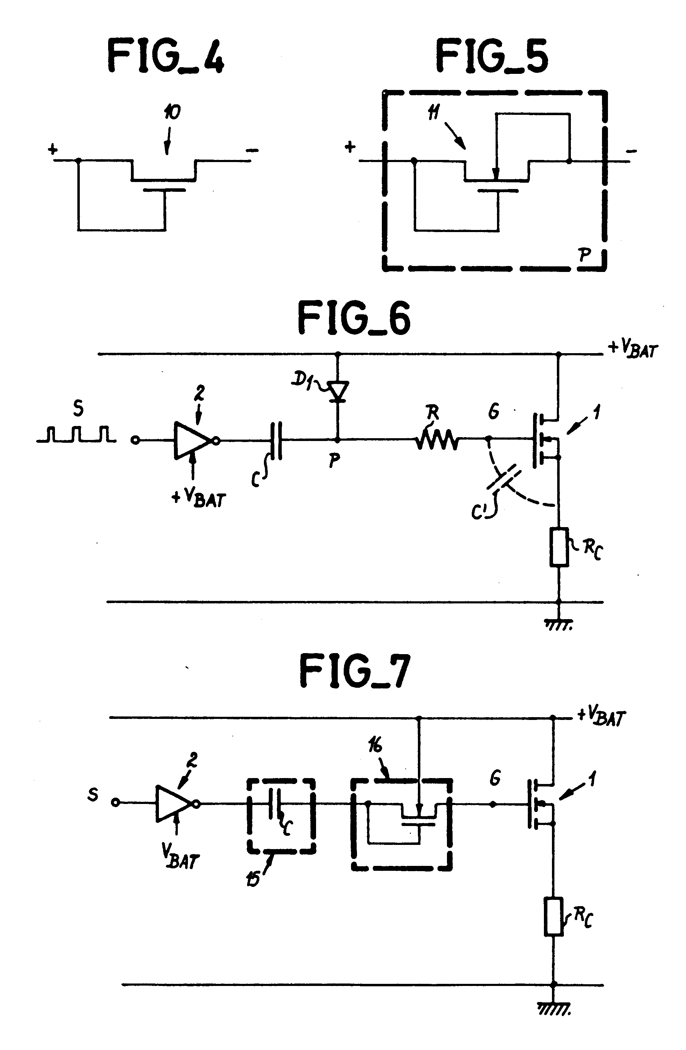

Il est connu de fabriquer une diode à partir d'un transistor MOS en reliant sa grille à l'une des deux autres électrodes du transistor. La figure 4 montre un transistor 10 disposé de telle sorte. Les polarités de la diode équivalente sont indiquées sur la figure. Cette solution réalisée à partir des mêmes opérations de diffusion que le VD MOS n'est cependant pas possible à cause de l'effet de substrat qui interdirait la conduction de la diode D2 réalisée à partir d'un tel transistor.

Il est également connu pour remédier à cet effet de substrat de réaliser une diode de la manière indiquée par la figure 5. Un transistor MOS référencé 11 est élaboré dans un caisson P; sa grille est reliée à son drain et sa source au substrat. Cette solution n'est pas possible non plus car le caisson de type P sera polarisé en direct par rapport au substrat. Il n'y a plus alors d'isolation par jonction.

L'invention propose de remplacer cette diode D2 par une résistance R comme le montre la figure 6 et de modifier le rapport cyclique du signal d'horloge. Un circuit dans lequel est prévu une résistance similaire est décrit dans New Electronics, 25 juin 85, P. 25, G. Peckham, mais ce circuit comprend inévitablement un condensateur de haute valeur, non intégrable, et ne met le transistor MOS en conduction que pendant une phase du signal d'horloge. Avec un faible rapport cyclique la résistance se comportera comme une diode. Le rapport cyclique sera choisi de préférence de telle façon que le temps de charge de la capacité C soit faible par rapport au temps de décharge de cette capacité vers la grille du VD MOS. Pour que la capacité C se charge le plus vite possible il faut que la résistance de sortie R' du circuit précédent la capacité C (en l'occurence l'inverseur 2) soit suffisamment faible par rapport à la résistance R. Un fonctionnement correct peut être obtenu pour R' environ 10 fois plus petite que R et pour un rapport cyclique du signal S d'horloge de 10 à 20 % (c'est-à-dire que la durée du signal S de valeur "1" est 4 à 9 fois plus faible que la période de ce signal).

Une méthode pratique pour réaliser une résistance sur un substrat semiconducteur est d'utiliser un MOS à déplétion et à canal N. Ce transistor sera réalisé à partir d'un caisson P qui devra être relié au potentiel le plus positif possible, c'est-à-dire au potentiel + $V_{BAT}$ pour minimiser l'effet de substrat. Ce faisant, on peut utiliser l'une des deux diodes existant entre le substrat (c'est-à-dire le caisson P) du transistor MOS à déplétion et ses électrodes de source et de drain comme diode $D_1$. La capacité C pourra être obtenue à partir d'un caisson P recouvert d'une couche d'isolant elle-même recouverte d'une électrode. Le schéma électrique associé à la structure semiconductrice est alors celui représenté à la figure 7. La capacité C sera obtenue à partir d'un caisson P référencé 15 et le N MOS à déplétion sera élaboré à partir d'un caisson P référencé 16.

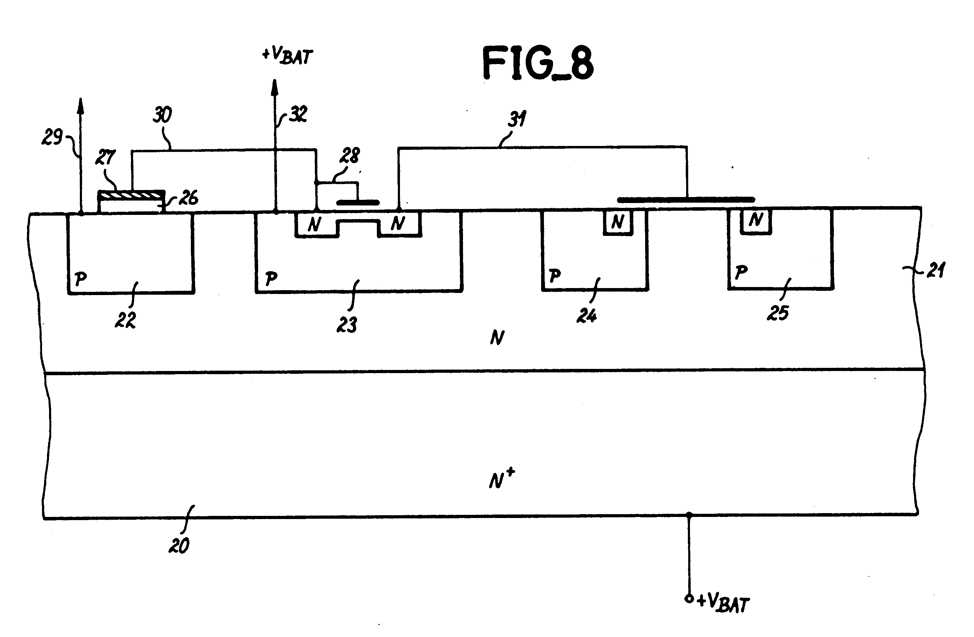

La figure 8 représente une structure semiconductrice associant un transistor de puissance du type VD MOS et un multiplicateur de tension continue. Cette structure a été élaborée à partir d'un substrat 20 en silicium dopé N$^+$ et comportant une couche épitaxiale 21 dopée N. A partir de la couche épitaxiale 21, on a réalisé des caissons P au cours d'une même opération. Le caisson 22 servira de support au condensateur C, le caisson 23 servira de substrat au N MOS à déplétion et les caissons 24 et 25 permettront d'élaborer le VD MOS. Chacune des opérations suivantes est connue en soi. Les zones de type N des transistors sont implantées au cours de la même opération. L'élaboration des transistors ne pose pas de problème et ne sera pas décrite plus en détail. Sur le caisson 22, une couche d'isolant 26 est déposée suivie d'un contact 27. L'isolant peut être de l'oxyde de silicium $SiO_2$ et le contact peut être du silicium polycristallin. Des connexions seront déposées pour relier la grille du MOS à déplétion à l'une de ses zones de type N (connexion 28), le caisson 22 à la sortie de l'inverseur (connexion 29), le contact 27 à l'une des extrémités de la résistance constituée par le N MOS à déplétion (connexion 30), l'autre extrémité de la résistance à la grille du VD MOS (connexion 31) et le caisson 23 au potentiel + $V_{BAT}$ (connexion 32).

Le dispositif selon l'invention a l'avantage de ne pas exiger d'opérations supplémentaires. L'inverseur peut être intégré sans problème sur le substrat. La description a porté sur une structure élaborée à partir d'un substrat de type N mais l'adaptation à un substrat de type P est aisée.

La structure développée par l'invention résulte de la solution apportée à une suite de problèmes qui sont apparus quand on a voulu intégrer un multiplicateur de tension continue sur un substrat semiconducteur particulier. Le schéma électrique qui est à la base de l'invention (résistance R, rapport cyclique particulier du signal d'horloge) pourrait cependant être utilisé en dehors du domaine des semiconducteurs pour résoudre des problèmes spécifiques.

**Revendications**

1.  Multiplicateur d'une tension continue ayant une valeur déterminée par rapport a un point de référence et comprenant au moins une cellule de type doubleur de tension par charge et décharge d'un condensateur et commandé par un signal d'horloge, le multiplicateur étant destiné à fournir un signal de commande à un transistor MOS puissance présentant une capacité d'entrée (C') de valeur determinée, comprenant :
    - des moyens électroniques permettant de mettre une première électrode du condensateur (C) au potentiel de point de référence en fonction de signal d'horloge (S),
    - une diode ($D_1$) reliée à la seconde électrode de condensateur et permettant le passage du courant de charge sous l'effet de la tension continue de valeur déterminée, cette charge s'effectuant lorsque la première électrode du condensateur (C) est mise au potentiel du point de référence,

- une résistance reliant le point commun (P) entre la diode (D$_1$) et le condensateur (C) à la grille du transistor à commander caractérisé en ce que les éléments de ce multiplicateur (2, C, D$_1$, R) et le transistor MOS de puissance sont intégrés sur un même substrat, en ce que le signal d'horloge (S) possède un rapport cyclique tel que la durée de charge du condensateur (C) soit inférieure à son temps de décharge, et en ce que la valeur de condensateur, la valeur de la résistance, et les caractéristiques des moyens électroniques sont choisies pour que la tension sur la grille du transistor atteigne une valeur propre à mettre en conduction le transistor MOS au bout d'un certain nombre de cycles de signal d'horloge et à le maintenir en conduction tant que le signal d'horloge est appliqué.

2. Multiplicateur selon la revendication 1, caractérisé en ce que ladite résistance (R) est environ dix fois plus grande que la résistance de sortie desdits moyens électroniques et que le rapport cyclique du signal d'horloge est tel que le temps de charge du condensateur (C) soit 4 à 9 fois plus faible que son temps de décharge.

3. Multiplicateur selon l'une des revendications 1 ou 2, caractérisé en ce que la résistance reliée au dispositif à commander est réalisée au moyen d'un transistor MOS à déplétion (16) ayant sa grille reliée à l'une de ses deux autres électrodes.

4. Multiplicateur selon la revendication 3, caractérisé en ce que le dispositif à commander est un VD MOS (1) élaboré à partir d'un substrat de type N, le substrat comprenant également un premier caisson (23) de type P permettant d'élaborer ledit transistor MOS à déplétion et un second caisson (22) de type P permettant d'élaborer ledit condensateur (C).

5. Multiplicateur selon la revendication 4, caractérisé en ce que le premier caisson (23) est porté au potentiel de ladite tension continue de valeur déterminée, ladite diode (D$_1$) étant alors constituée par la jonction existant entre la zone de type P dudit premier caisson et la zone de type N du transistor MOS à déplétion qui est reliée au condensateur (C).

6. Multiplicateur selon l'une quelconque des revendications 1 à 5, caractérisé en ce que lesdits moyens électroniques sont constitués par un inverseur (2).

**Claims**

1. A multiplier of a direct voltage with a determined value in relation to a reference point, comprising at least one cell of the voltage doubler type, operating by the charging and discharging of a capacitor and controlled by a clock signal, the multiplier being designed to give a control signal to a power MOS transistor that has an input capacity (C') of a determined value, comprising:
   - electronic means by which a first electrode of the capacitor (C) can be set at the potential of the reference point according to the clock signal (S),
   - a diode (D1) connected to the second electrode of the capacitor, providing for the passage of charging current under the effect of the direct voltage of determined value, this charge taking place when the first electrode of the capacitor (C) is set at the potential of the reference point,
   - a resistor (R) linking the common point (P) between the diode (D1) and the capacitor (C) to the gate of the transistor to be controlled,
   characterized in that the elements of said multiplier (2, C, D1, R) and the power MOS transistor are integrated on a single substrate, in that the clock signal (S) has a duty cycle such that the charging time of the capacitor (C) is smaller than its discharging time, and in that the capacitor value, the resistor value, and the characteristics of the electronic means are chosen so that the voltage on the gate of the transistor reaches a suitable value for turning the MOS transistor on after a determined number of clock signal cycles and for maintaining said transistor on as long as the clock signal is applied.

2. A multiplier according to claim 1, characterized in that the resistance of said resistor (R) is about 10 times greater than the output resistance of said electronic means, and the duty cycle of the clock signal is such that the charging time of the capacitor (C) is 4 to 9 times smaller than its discharging time.

3. A multiplier according to claim 1 or 2, characterized in that the resistor linked to the device to be controlled is made by means of a depletion-mode MOS transistor (16) having its gate connected to one of its two other electrodes.

4. A multiplier according to claim 3, wherein the device to be controlled is a VD MOS (1) made from an N type substrate, the substrate also comprising a first P type well (23) in which said depletion-mode transistor can be made and a second P type well (22) in which said capacitor can be made.

5. A multiplier according to claim 4, characterized in that the first well (23) is taken to the potential of said direct voltage with a determined value, said diode (D1) being then formed by the junction that exists between the P type region of the first well and the N type region of the depletion-mode MOS transistor which is connected to the capacitor.

6. A multiplier according to any of claims 1 to 5, characterized in that said electronic means comprises an inverter (2).

**Patentansprüche**

1. Gleichspannungsvervielfacher, der einen bestimmten Spannungswert in bezug zu einem Referenzpunkt hat und mindestens eine Spannungsverdoppelungszelle aufweist, die einen Kondensator lädt bzw. entlädt und von einem Taktsignal gesteuert wird, wobei der Vervielfacher zum Liefern eines Steuersignales an einen MOS-Leistungstransistor, der eine Eingangskapazität (C') bestimmten Wertes aufweist, ausgebildet ist und folgende Merkmale umfaßt:
   - eine elektronische Schaltung zum Setzen einer ersten Elektrode des Kondensators (C) auf das Potential des Bezugspunktes in Abhängigkeit des Taktsignales (S),
   - eine Diode (D1), die mit der zweiten Elektrode des Kondensators verbunden ist und einen Ladestromfluß unter der Wirkung der Gleichspannung mit dem bestimmten Spannungswert zuläßt, wobei der Ladevorgang abläuft, solange die erste Elektrode des Kondensators (C) auf das Potential des Bezugspunktes gesetzt ist,
   - einen Widerstand (R), der den gemeinsamen Schaltungspunkt (P) zwischen der Diode (D1) und dem Kondensator (C) mit der Steuerelektrode des Steuertransistors verbindet,
dadurch gekennzeichnet, daß die Elemente dieses Vervielfachers (2, C, D1, R) und der MOS-Leistungstransistor auf einem einzigen gemeinsamen Substrat integriert sind, daß das Taktsignal (S) einen solchen Arbeitszyklus aufweist, daß die Ladezeit des Kondensators (C) kleiner als dessen Endladezeit ist, und daß der Wert des Kondensators, der Wert des Widerstandes und die charakteristischen Werte der elektronischen Schaltung so gewählt sind, daß die Spannung an der Steuerelektrode des Transistors einen passenden Wert erreicht, um den MOS-Transistor nach einer bestimmten Anzahl von Arbeitszyklen des Taktsignales in den leitenden Zustand zu versetzen und ihn im leitenden Zustand zu halten, solange das Taktsignal angelegt ist.

2. Vervielfacher nach Anspruch 1, dadurch gekennzeichnet, daß der Widerstand (R) etwa zehn Mal so groß ist wie der Ausgangswiderstand der elektronischen Schaltung und daß der Arbeitszyklus des Taktsignales derart ist, daß die Ladezeit des Kondensators (C) 4- bis 9-fach kleiner als die Entlade zeit ist.

3. Vervielfacher nach einem der Ansprüche 1 oder 2, dadurch gekennzeichnet, daß der Widerstand, der mit der Steuerschaltung verbunden ist, mit Hilfe eines MOS-Transistors des Verarmungstyps (16) realisiert ist, dessen Steuerelektrode mit einer seiner beiden anderen Elektroden verbunden ist.

4. Vervielfacher nach Anspruch 3, dadurch gekennzeichnet, daß die Steuerschaltung ein VD-MOS (1) ist, der ausgehend von einem Substrat vom Typ N aufgebaut ist, wobei das Substrat ferner einen ersten Bereich (23) vom P-Typ zum Aufbauen des MOS-Transistors vom Verarmungstyp und einen zweiten Bereich (22) vom P-Typ zum Aufbauen des Kondensators (C) umfaßt.

5. Vervielfacher nach Anspruch 4, dadurch gekennzeichnet, daß der erste Bereich (23) auf das Potential der Gleichspannung mit bestimmtem Wert angehoben ist, und daß die Diode (D1) durch die Grenzschicht zwischen der Zone vom P-Typ des ersten Bereiches und der Zone vom N-Typ des MOS-Transistors vom Verarmungstyp, der mit dem Kondensator (C) verbunden ist, gebildet ist.

6. Vervielfacher nach einem der Ansprüche 1 bis 5, dadurch gekennzeichnet, daß die elektronische Schaltung durch einen Inverter (2) gebildet ist.

FIG_1

FIG_2

FIG_3

# FIG_4

# FIG_5

# FIG_6

# FIG_7

# FIG_8

EP 0 240 436 B1